# EUROPÄISCHE PATENTSCHRIFT

(11) **EP 2 281 316 B1**
(45) Veröffentlichungstag und Bekanntmachung des Hinweises auf die Patenterteilung: **10.06.2015**
(21) Anmeldenummer: 09753512.4
(22) Anmeldetag: 20.04.2009
(51) Int. Cl.: H01L 33/48, H05K 1/03

(54) **OPTOELEKTRONISCHES HALBLEITERBAUTEIL**
OPTOELECTRONIC SEMICONDUCTOR COMPONENT
COMPOSANT SEMICONDUCTEUR OPTOELECTRONIQUE

(30) Priorität: 28.05.2008 DE 102008025491
(43) Veröffentlichungstag der Anmeldung: 09.02.2011
(73) Patentinhaber: OSRAM Opto Semiconductors GmbH, 93055 Regensburg (DE); Shin-Etsu Chemical Co., Ltd., Tokyo 100-0004 (JP)
(72) Erfinder: JÄGER, Harald, 93049 Regensburg (DE); SORG, Jörg, Erich, 93053 Regensburg (DE); KASHIWAGI, Tsutomu, 379-0100 Annaka-shi Gunma-ken (JP); SHIOBARA, Toshio, 379-0100 Annaka-shi Gunma-ken (JP)
(74) Vertreter: Epping - Hermann - Fischer
(86) Internationale Anmeldenummer: PCT/DE2009/000543
(87) Internationale Veröffentlichungsnummer: WO 2009/143796

(56) Entgegenhaltungen:
- EP-A- 1 187 228
- EP-A- 1 657 758
- WO-A-2005/072031
- WO-A-2006/099741
- US-A1- 2004 166 332
- US-A1- 2008 068 845

## Beschreibung

Es wird ein optoelektronisches Halbleiterbauteil angegeben.

Optoelektronische Bauelemente wie etwa Leucht- oder Fotodioden haben eine breite technische Anwendung gefunden. Einige Gesichtspunkte, die der Verbreitung solcher Bauelemente Vorschub leisteten, sind etwa deren hohe Effizienz und Widerstandsfähigkeit gegen äußere Belastungen sowie Umwelteinflüsse. Beispielsweise können optoelektronische Bauelemente etwa Feuchtigkeit oder Wärme gut widerstehen und sind auch bei geeigneter Bauart widerstandsfähig gegen mechanische Beanspruchungen. Neben hoher Effizienz weisen optoelektronische Bauelemente auch eine hohe Lebensdauer, eine kompakte Bauweise und vielfältige Ausgestaltungsmöglichkeiten auf und sind außerdem zu vergleichsweise geringen Fertigungskosten herstellbar. Entscheidend für eine Vielzahl der eben genannten Eigenschaften ist oft die Hausung eines optoelektronischen Bauteils, in dem ein Bauelement untergebracht ist.

In der Druckschrift WO 2005/072031 A2 ist eine Leiterplatte angegeben.

Die Druckschrift EP 1 187 228 A1 betrifft eine Lichtquelle.

Eine Hybridleiterplatte mit einem organischen Material und einer Faserverstärkung ist in der Druckschrift US 2004/0166332 A1 beschrieben.

Eine Festkörperlichtquelle ist in der Druckschrift WO 2006/099741 A1 offenbart.

In der Druckschrift EP 1 657 758 A2 ist eine Leuchtdiode mit gegossenen Linsen wiedergegeben.

Ein optisches Bauteil ist in der Druckschrift US 2008/0068845 A1 angegeben.

Eine zu lösende Aufgabe besteht darin, ein optoelektronisches Halbleiterbauteil anzugeben, das UV- und temperaturbeständig ist.

Die Erfindung ist im Anspruch 1 offenbart. Weitere Ausgestaltungen der Erfindung werden in den abhängigen Ansprüchen definiert.

Das optoelektronische Halbleiterbauteil weist einen Anschlussträger auf. Der Anschlussträger ist bevorzugt flächig ausgestaltet, das heißt, seine laterale Ausdehnung ist wesentlich größer als seine Dicke. Der Anschlussträger umfasst einen Grundkörper. Der Grundkörper weist bevorzugt zwei einander gegenüberliegende Hauptseiten auf. Mindestens eine der Hauptseiten ist dazu ausgestaltet, darauf einen Halbleiterchip anzubringen. Beide Hauptseiten können eben ausgestaltet sein. Ebenso kann mindestens eine der Hauptseiten Strukturierungen aufweisen, die beispielsweise in Form von Ausnehmungen oder Mulden gestaltet sein können und etwa zur Aufnahme eines Halbleiterelements dienen.

Der Grundkörper des Anschlussträgers weist weiterhin Trägerflanken auf, die durch diejenigen Flächen gebildet werden, die die beiden Hauptseiten miteinander verbinden. Hauptseiten oder Trägerflanken können auch Mikro- oder Nanostrukturierungen aufweisen, über die beispielsweise das Haftungsvermögen der strukturierten Flächen zum Beispiel an einem externen Träger oder an aufzubringenden Beschichtungen verbessert werden kann.

Es weist der Anschlussträger neben dem Grundkörper mindestens zwei Anschlussstellen auf. Die Anschlussstellen sind dazu ausgestaltet, ein elektrisches Kontaktieren des Anschlussträgers etwa zu einem Halbleiterbauelement und/oder zu einem externen, nicht zum Halbleiterbauteil gehörigen Träger zu ermöglichen. Die Anschlussstellen können mit einem Metall oder einer Metalllegierung gebildet sein. Beispielsweise können die Anschlussstellen Kupfer, Nickel, Gold, Palladium oder Silber enthalten oder gänzlich aus einem dieser Materialien oder aus einer Materialkombination hergestellt sein. Ebenso ist es möglich, dass die Anschlussstellen mit einem transparenten, elektrisch leitfähigen Material, wie beispielsweise einem Metalloxid, auch als transparent conductive oxides bezeichnet, kurz TCO, gebildet sind. Der Grundkörper kann vom Material der Anschlussstellen bedeckt sein. Es ist möglich, dass die Anschlussstellen zumindest teilweise über ein Druck- oder Siebdruckverfahren aufgebracht sind. Ebenfalls kann der Anschlussträger als großflächige Leiterplatte, auch als Printed Circuit Board bezeichnet, ausgeführt sein. Der Anschlussträger kann zur Montage mit einer Vielzahl von Halbleiterchips vorgesehen sein, wobei der Anschlussträger auch vor oder nach einer Montage in einzelne, kleinere Einheiten separiert werden kann.

Bevorzugt sind die Anschlussstellen derart ausgestaltet, dass eine Verbindung zu einem Halbleiterbauelement oder zu einem externen Träger über Löten hergestellt werden kann. In diesem Fall ist das Halbleiterbauteil bevorzugt beständig gegenüber die bei einem Lötprozess auftretenden thermischen Belastungen. Über einen derartigen Anschlussträger kann auf effiziente Weise eine Kontaktierung etwa zu einem externen, nicht zum Halbleiterbauteil gehörigen Träger realisiert werden.

Das optoelektronische Halbleiterbauteils umfasst mindestens ein Halbleiterbauelement in Form eines optoelektronischen Halbleiterchips. Der Halbleiterchip kann als Leuchtdiode, als Laserdiode oder als Fotodiode ausgestaltet sein. Ebenso kann das Halbleiterbauelement mit organischem Material gebildet und beispielsweise eine organische Leuchtdiode sein oder basiert auf GaN, GaP oder GaAs. Der Halbleiterchip kann mindestens zum Teil Licht im Spektralbereich zwischen zirka 200 nm und 4 µm, insbesondere im nahen ultravioletten oder blauen Spektralbereich zwischen zirka 340 nm und 480 nm, emittieren.

Es steht der Halbleiterchip in direktem Kontakt zum Anschlussträger, das heißt der Halbleiterchip hat physischen Kontakt zum Grundkörper oder zu den Anschlussstellen des Anschlussträgers. "Physischer Kontakt" schließt nicht aus, dass sich zwischen Halbleiterchip und Anschlussträger eine Haft vermittelnde Schicht, die etwa aus einem Lot oder einem Kleber gestaltet ist, befindet. Durch den direkten Kontakt von Halbleiterchip zum Anschlussträger wird eine gute thermische Ankopplung des Halbleiterchips an den Anschlussträger gewährleistet. Die im Betrieb des Halbleiterchips entstehende Abwärme kann hierdurch effektiv vom Halbleiterchip abgeführt werden.

Es ist der Grundkörper des Anschlussträgers mit einer Silikonmatrix mit einer Faserverstärkung gestaltet. "Silikonmatrix" bedeutet hierbei, dass das Material, das die Matrix ausbildet, ein Silikon ist oder aber auch, dass das Material ein Silikon enthält. Das die Matrix bildende Material kann dann ein Silikonhybridmaterial sein. Das Material enthält dann, neben Silikon, ein Epoxid. Silikon weist eine hohe Temperatur- und UV-Beständigkeit auf, ist transparent im sichtbaren Spektralbereich und eignet sich daher gut als Matrixmaterial für den Anschlussträger. In die Silikonmatrix ist eine Faserverstärkung eingebettet. Die Faserverstärkung besteht bevorzugt aus mehreren Lagen an Fasern, wobei sich die einzelnen Ebenen bevorzugt längs einer Hauptseite des Anschlussträgers erstrecken. Innerhalb einer Ebene der Faserverstärkung können die sich in dieser Ebene befindlichen Fasern im Wesentlichen parallel ausgerichtet sein. Weist der elektrisch isolierende Grundkörper mehrere Ebenen einer Faserverstärkung auf, so sind die Ebenen bevorzugt gegeneinander verdreht angeordnet, wobei sich "verdreht" auf eine Achse senkrecht zu einer Hauptseite des Anschlussträgers bezieht. Bevorzugt sind die einzelnen Ebenen um 90° gegeneinander verdreht. Als Material für die Faserverstärkung kann ein solches Material dienen, das eine gute Haftung am Matrixmaterial sowie eine hohe mechanische Belastbarkeit aufweist. Ebenfalls ist das Material der Faserverstärkung bevorzugt mindestens so temperaturbeständig wie die Silikonmatrix und weist einen geringen thermischen Ausdehnungskoeffizienten auf.

Das optoelektronische Halbleiterbauteil umfasst einen Anschlussträger mit mindestens zwei Anschlussstellen, mindestens einen optoelektronischen Halbleiterchip, der am Anschlussträger angebracht ist und in direktem Kontakt zu diesem steht, wobei der Anschlussträger mit einer Silikonmatrix mit einer Faserverstärkung gestaltet ist. Durch die Verwendung eines Anschlussträgers mit einer Silikonmatrix mit einer Faserverstärkung kann ein mechanisch stabiles und dabei temperatur- und UV-beständiges Halbleiterbauteil realisiert werden. Insbesondere bei Hochleistungsdioden, die hohe optische Ausgangsleistungen aufweisen und somit auch signifikant Abwärme produzieren, sind hohe Anforderungen an die Temperaturbeständigkeit gestellt. Dies gilt ebenso für die Verwendung des Bauteils zum Beispiel in Umgebungen mit erhöhter Temperatur, zum Beispiel in einem Autoscheinwerfer in Motornähe.

Insbesondere bei Verwendung von Halbleiterchips, die blaues oder UV-Licht emittieren, ist, um eine hohe Lebensdauer des Halbleiterbauteils zu realisieren, der Anschlussträger UVbeständig auszugestalten. Diesen Anforderungen kann das optoelektronische Halbleiterbauteil gerecht werden.

Gemäß zumindest einer Ausführungsform des optoelektronischen Halbleiterbauteils ist die Faserverstärkung mit Glasfasern gebildet. Glasfasern weisen eine gute UV- und Temperaturbeständigkeit auf. Weiterhin gewährleistet die Verwendung von Glasfasern eine gute Haftung von dem Matrixmaterial Silikon mit der Faserverstärkung. Glasfasern stellen zudem ein kostengünstiges und leicht zu handhabendes Material dar.

Gemäß zumindest einer Ausführungsform des optoelektronischen Halbleiterbauteils ist die Faserverstärkung vollständig von der Silikonmatrix umgeben. Hierdurch sind die außen liegenden Flächen des Grundkörpers des Anschlussträgers aus demselben Material, nämlich Silikon, gebildet. Dies erleichtert ein Anbringen etwa von Beschichtungen auf dem Grundkörper. Weiterhin sind die Fasern von der Silikonmatrix geschützt, so dass beispielsweise keine Migration von Metallionen entlang der Fasern stattfinden kann, da keine Metalle beziehungsweise Metallionen zu den im Silikon eingebetteten Fasern gelangen.

Gemäß zumindest einer Ausführungsform des optoelektronischen Halbleiterbauteils weist die Faserverstärkung mindestens drei Ebenen auf. Die Ebenen sind bevorzugt gegeneinander verdreht angeordnet. Besonders bevorzugt weist die Faserverstärkung vier Ebenen auf, die jeweils um 90° bezüglich einer Achse senkrecht zu einer Hauptseite des Anschlussträgers gegeneinander gedreht angeordnet sind. Über eine derartige, mehrlagige Ausgestaltung der Faserverstärkung des Grundkörpers kann ein mechanisch stabiler Anschlussträger realisiert werden.

Gemäß zumindest einer Ausführungsform des optoelektronischen Halbleiterbauteils sind die Anschlussstellen mit mindestens einer Metallisierung gebildet. Die Metallisierung kann aus mehreren Schichten, auch unterschiedlicher Metalle beziehungsweise Metalllegierungen, bestehen. Bevorzugt ist eine erste, dem Anschlussträger am nächsten liegende Metallisierungsschicht mit Kupfer gebildet. Die Schichtdicke des Kupfers beträgt bevorzugt weniger als 150 µm, besonders bevorzugt weniger als 50 µm. Alternativ oder zusätzlich können weitere Metallisierungsschichten aus Nickel, Palladium, Gold und/oder Silber aufgebracht sein. Die Dicken dieser weiteren Schichten sind bevorzugt < 25 µm, besonders bevorzugt < 5 µm, ganz besonders bevorzugt < 2 µm. Solche Metallisierungsschichten sind kosteneffizient und mit geringem Aufwand aufzubringen und können zudem effektiv strukturiert werden.

Gemäß zumindest einer Ausführungsform des optoelektronischen Halbleiterbauteils weist sowohl eine Trägeroberseite als auch eine Trägerunterseite, die jeweils durch eine Hauptseite des Anschlussträgers gebildet sind, mindestens eine Metallisierung auf. Die an Trägerober- beziehungsweise Trägerunterseite aufgebrachten Metallisierungen können als eine einzige, durchgehende Metallisierung gestaltet sein, verbunden etwa über die Trägerflanken. Die Metallisierung kann über Tauchverfahren, Aufdampfung, Aufsputtern oder über elektrogalvanische oder galvanische Verfahren hergestellt sein. Bevorzugt ist die mindestens eine Metallisierung so strukturiert, dass elektrisch voneinander isolierte Bereiche gebildet sind, die etwa zur Kontaktierung eines Halbleiterchips oder zur Kontaktierung mit einem externen Träger, insbesondere mittels Löten, geeignet sind. Bevorzugt bedeckt die Metallisierung einen Großteil der Oberfläche des Grundkörpers, zum Beispiel mehr als 50 %. Da Metalle in der Regel eine hohe thermische Leitfähigkeit aufweisen, kann über ein großflächiges Aufbringen wenigstens einer Metallisierung ein eine hohe thermische Leitfähigkeit aufweisender Anschlussträger gebildet sein.

Gemäß zumindest einer Ausführungsform des optoelektronischen Halbleiterbauteils ist der Silikonmatrix des Grundkörpers mindestens eine Beimengung beigegeben. Die Beimengung kann beispielsweise als Diffusionsmittel, als Farbstoff, als Filtermittel, als Reflexionsmittel, als Konversionsmittel etwa in Form eines Lumineszenzfarbstoffs, als Füllstoff zur Anpassung des thermischen Ausdehnungskoeffizienten oder als Haftvermittler ausgestaltet sein. Über derartige Beimengungen kann insbesondere das optische Verhalten des Anschlussträgers, also ob dieser beispielsweise reflektierend, transmittierend oder absorbierend ist, bestimmt werden. Durch die Verwendung einer oder auch mehrerer Beimengungen erhöhen sich die Ausgestaltungsmöglichkeiten des Anschlussträgers.

Gemäß zumindest einer Ausführungsform des optoelektronischen Halbleiterbauteils ist eine elektrische Verbindung zwischen Trägeroberseite und Trägerunterseite über Durchkontaktierungen erfolgt. Der Anschlussträger weist beispielsweise tunnelartige Durchbrüche auf. Die Durchbrüche können etwa über Bohren, Laserbohren oder Stanzen erstellt werden. Ebenso ist es möglich, dass die Durchbrüche bereits beim Herstellen des Anschlussträgers, beispielsweise beim Gießen, gebildet werden. Die durch diese Durchbrüche oder Ausnehmungen zusätzlich neben Trägerflanken, Trägeroberbeziehungsweise Trägerunterseite gebildeten Flächen können mit einer Metallisierung versehen sein, die den elektrischen Kontakt zwischen Trägerober- und Trägerunterseite herstellt, oder auch gänzlich mit einem elektrisch leitfähigen Material ausgefüllt sein. Über Durchkontaktierungen erhöhen sich die Gestaltungsmöglichkeiten des Halbleiterbauteils und eine Platz sparende elektrische Verbindung zwischen den Hauptseiten des Anschlussträgers ist realisierbar.

Gemäß zumindest einer Ausführungsform des optoelektronischen Halbleiterbauteils erfolgt die elektrische Verbindung zwischen Trägeroberseite und Trägerunterseite über mindestens eine Metallisierung an mindestens einer Trägerflanke. Eine derartige Metallisierung ist leicht aufzubringen und eine zusätzliche Strukturierung des Anschlussträgers kann entfallen. Bevorzugt erstreckt sich die Metallisierung auf nur zwei einander gegenüberliegenden Trägerflanken.

Gemäß zumindest einer Ausführungsform des optoelektronischen Halbleiterbauteils ist der mindestens eine Halbleiterchip von mindestens einem Vergusskörper überdeckt. Der Vergusskörper steht bevorzugt in direktem Kontakt zum Halbleiterchip. Der Vergusskörper ist bevorzugt über ein leicht schmelz- oder pressbares Material gebildet, das für die vom Halbleiterchip zu empfangende oder zu emittierende Strahlung bevorzugt mindestens teilweise transparent oder transluzent ausgestaltet ist. Geeignete Materialien stellen beispielsweise Silikone, Epoxide, Silikon-Epoxid-Hybride oder Kunststoffe wie Polykarbonat dar, wobei Silikone bevorzugt sind, da diese eine gute Haftung zu der Silikonmatrix des Grundkörpers aufweisen. Außerdem sind Silikone UValterungsbeständig und hochtemperaturstabil. Der Vergusskörper kann beispielsweise über Formpressen (Compression Molding), Flüssigspritzpressen (Liquid Transfer Molding), Flüssigspritzgießen (Liquid Injection Molding) oder Gießen (Casting) erzeugt werden. Ein derartiger Vergusskörper kann effizient aufgebracht werden, bietet dem Halbleiterchip einen guten Schutz und erhöht die Ausgestaltungsmöglichkeiten des Halbleiterbauteils.

Dieselben Herstellungsverfahren wie für den Vergusskörper eignen sich auch zur Herstellung des Grundkörpers des Anschlussträgers.

Das optoelektronische Halbleiterbauteil umfasst einen Anschlussträger mit mindestens zwei Anschlussstellen, mindestens einen optoelektronischen Halbleiterchip, der am Anschlussträger angebracht ist und in direktem Kontakt zu diesem steht, wobei der Anschlussträger mit einer Silikonmatrix mit einer Glasfaserverstärkung gestaltet ist. Weiterhin umfasst das Halbleiterbauteil einen Vergusskörper aus einem silikonhaltigen Material, wobei der Vergusskörper mindestens stellenweise in direktem Kontakt zum Grundkörper steht.

Bei einem solchen Halbleiterbauteil sind Anschlussträger und Vergusskörper beständig gegen UV-Strahlung und weisen eine gute Haftung aneinander auf, da beide mit einem Silikon gestaltet sind. Zudem sind die thermischen Ausdehnungskoeffizienten von Anschlussträger und Vergusskörper hierdurch nahezu gleich. Grundkörper des Anschlussträgers und Vergusskörper können eine große Kontaktfläche zueinander aufweisen. Die Gefahr einer Delamination des Vergusskörpers vom Anschlussträgers ist signifikant verringert.

Es ist der mindestens eine Halbleiterchip von mindestens einem Glaskörper überdeckt. Der Glaskörper ist über einen rahmenartigen Zwischenträger mit dem Anschlussträger verbunden. Glas weist eine hohe mechanische Beständigkeit gegenüber beispielsweise Verkratzen auf und bietet dem Halbleiterchip einen guten Schutz vor äußeren Einflüssen.

Gemäß zumindest einer Ausführungsform des optoelektronischen Halbleiterbauteils weisen Vergusskörper und/oder Glaskörper mindestens eine Beimengung auf. Weist das Halbleiterbauteil sowohl einen Glaskörper als auch einen Vergusskörper auf, so können Glaskörper und Vergusskörper gleiche oder auch verschiedene Beimengungen beinhalten. Über die Verwendung von Beimengungen können die physikalischen und chemischen Eigenschaften von Vergusskörper und/oder Glaskörper über einen weiten Bereich eingestellt werden.

Gemäß zumindest einer Ausführungsform des Halbleiterbauteils ist der Halbleiterchip von Anschlussträger und von Vergusskörper und/oder Glaskörper vollständig umgeben. "Vollständig umgeben" bedeutet, dass von Anschlussträger und Vergusskörper und/oder Glaskörper ein Hohlraum gebildet ist, in dem sich der Halbleiterchip befindet. Der Hohlraum kann vom Halbleiterchip vollständig ausgefüllt sein. Zwischen etwa Anschlussträger und Glaskörper kann ein Verbindungsmittel aufgebracht sein. Bevorzugt ist der Halbleiterchip, insbesondere falls dieser organische Komponenten aufweist, gas- und diffusionsdicht abgeschlossen. Über eine derartige Anordnung erfährt der mindestens eine Halbleiterchip einen hohen Schutz vor Umwelteinflüssen.

Gemäß zumindest einer Ausführungsform des optoelektronischen Halbleiterbauteils sind Vergusskörper und/oder Glaskörper als optisches Element ausgestaltet. Das optische Element kann durch Mikrolinsen, Fresnel-Linsen oder herkömmliche sphärische oder Zylinderlinsen gebildet sein. Ebenso können an Vergusskörper und/oder Glaskörper Strukturierungen oder reflektierende Schichten aufgebracht sein. Über die Ausgestaltung von Vergusskörper und/oder Glaskörper als optisches Element kann das vom Halbleiterchip zu empfangende oder zu emittierende Licht gezielt aus einem Raumbereich gesammelt oder in einen Raumbereich gelenkt werden.

Gemäß zumindest einer Ausführungsform des optoelektronischen Halbleiterbauteils sind Vergusskörper und/oder Glaskörper mehrlagig ausgestaltet. Das heißt, der Vergusskörper weist beispielsweise mehrere Schichten auf, die etwa aus Silikonen unterschiedlicher Härte gebildet sein können. Ebenso können die einzelnen Schichten unterschiedliche Beimengungen aufweisen, so dass eine erste Schicht beispielsweise mit einem Filtermittel, eine weitere Schicht mit einem Konversionsmittel und eine äußerste Schicht als optisches Element konzipiert sind. Weist das Halbleiterbauteil sowohl einen Vergusskörper als auch einen Glaskörper auf, so können diese auch gemeinsam als Mehrschichtsystem ausgeführt sein. Insbesondere ist dann auch eine Anpassung des optischen Brechungsindex der verschiedenen Materialien aneinander möglich, um eine effiziente Lichtaus- oder Lichteinkopplung zu erzielen.

Gemäß zumindest einer Ausführungsform des optoelektronischen Halbleiterbauteils umfasst der Anschlussträger mindestens eine Wärmesenke. Die Wärmesenke ist bevorzugt in den Grundkörper integriert und bevorzugt mit einem Material einer hohen Wärmekapazität und einer hohen Wärmeleitfähigkeit gebildet. Als Material kann beispielsweise ein Metall wie Kupfer oder eine Keramik wie AlN dienen. Bevorzugt ist die Wärmesenke so gestaltet, dass mindestens eine Ausnehmung im Grundkörper mit dem Material der Wärmesenke gefüllt ist. Anschlussstellen und Wärmesenke können, zumindest zum Teil, ineinander integriert sein. Die Wärmesenke gleicht thermische Spitzenbelastungen aus und verbessert die Abfuhr von Abwärme des Halbleiterchips weg vom optoelektronischen Halbleiterbauteil.

Gemäß zumindest einer Ausführungsform des optoelektronischen Halbleiterbauteils ist dieses bis zu Betriebstemperaturen von mindestens 130 °C, bevorzugt von mindestens 145 °C, besonders bevorzugt von mindestens 165 °C, ganz besonders bevorzugt von mindestens 175 °C temperaturbeständig. Das heißt, das Halbleiterbauteil kann bis zu der entsprechenden Temperatur betrieben werden, ohne dass eine signifikante Verringerung der beabsichtigten Lebensdauer des Bauteils auftritt. Derart hohe Betriebstemperaturen sind dadurch realisierbar, dass temperaturbeständige Silikone als Matrixmaterial des Grundkörpers Verwendung finden, und auch die weiteren Bestandteile des Halbleiterbauteils eine entsprechende Temperaturbeständigkeit aufweisen. Da Silikone relativ weich sind, lassen sich zudem thermische Spannungen zwischen Halbleiterchip und Anschlussträger minimieren. Hierdurch wird die Lebensdauer ebenso erhöht.

In einer Abwandlung der Erfindung wird eine Leiterplatte angegeben. Die Leiterplatte ist mit einer Silikonmatrix mit einer Faserverstärkung mit Glasfasern gebildet und weist mindestens zwei Anschlussstellen auf.

Die Leiterplatte kann beispielsweise wie in Verbindung mit einem oder mehreren der oben genannten Ausführungsformen für ein optoelektronisches Halbleiterbauteil ausgestaltet sein.

Einige Anwendungsbereiche, in denen hier beschriebene optoelektronische Bauteile oder Leiterplatten Verwendung finden könnten, sind etwa die Hinterleuchtung von insbesondere großflächigen Displays oder Anzeigeeinrichtungen, beispielsweise für TV-Geräte. Weiterhin können die hier beschriebenen optoelektronischen Bauteile etwa auch in Beleuchtungseinrichtungen zu Projektionszwecken, in Scheinwerfern oder Lichtstrahlern oder bei der Allgemeinbeleuchtung eingesetzt werden.

Nachfolgend wird ein hier beschriebenes Bauteil unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:
- Figur 1: eine schematische Seitenansicht A und eine schematische Draufsicht B einer Abwandlung eines Halbleiterbauteils,
- Figur 2: eine schematische Seitenansicht einer Schnittdarstellung einer Abwandlung eines Halbleiterbauteils,
- Figur 3: eine schematische Schnittdarstellung A sowie eine schematische Draufsicht B einer Abwandlung eines Halbleiterbauteils mit integrierten thermischen Reservoirs,
- Figur 4: eine schematische Schnittdarstellung einer Abwandlung eines Halbleiterbauteils mit Durchkontaktierungen,
- Figur 5: eine schematische Schnittdarstellung einer Abwandlung eines Halbleiterbauteils mit mehrlagigem Vergusskörper, und
- Figur 6: eine schematische Schnittdarstellung eines Ausführungsbeispiels eines hier beschriebenen Halbleiterbauteils mit Glaskörper und Vergusskörper.

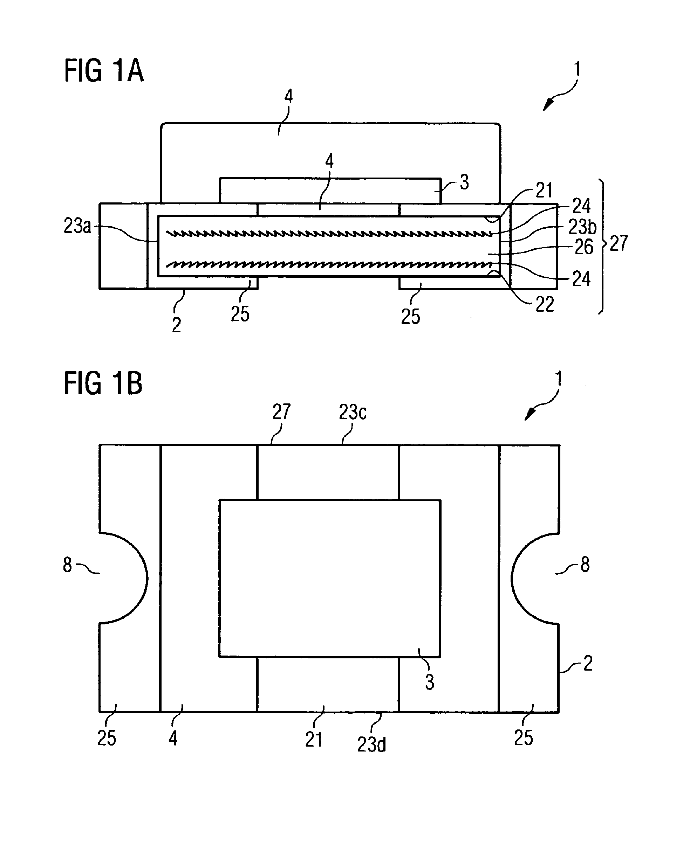

Figur 1 zeigt eine Abwandlung eines optoelektronischen Halbleiterbauteils 1. Figur 1A stellt eine Schnittdarstellung entlang der Strich-Punkt-Linie in Figur 1B dar.

Ein Grundkörper 27 eines Anschlussträgers 2 ist mit zwei Lagen einer Faserverstärkung 24 gebildet. Die Faserverstärkung 24 besteht aus Glasfasern. In jeder Lage der Faserverstärkung 24 sind die Fasern jeweils in einer Richtung parallel zu einer Trägeroberseite 21 ausgerichtet. Bezüglich einer Achse senkrecht zur Trägeroberseite 21 sind die Fasern beider Lagen der Faserverstärkung 24 um 90° gegeneinander gedreht. Die Faserverstärkung 24 ist in einer Silikonmatrix 26 eingebettet, wobei das Matrixmaterial die Faserverstärkung 24 allseitig vollständig umgibt.

Gegenüber der Trägeroberseite 21 des Anschlussträgers 2 befindet sich eine Trägerunterseite 22. Trägeroberseite 21 und Trägerunterseite 22 sind über Trägerflanken 23a-d bildende Flächen miteinander verbunden. Der Grundkörper 27 weist zwei Ausnehmungen 8 auf, die von der Trägeroberseite 21 zur Trägerunterseite 22 reichen und die Trägerflanken 23 unterbrechen. Über die Ausnehmungen 8 kann eine Montage des Halbleiterbauteils 1 an einem nicht gezeichneten, externen nicht zum Halbleiterbauteil 1 gehörenden Träger erleichtert werden.

Sowohl an Trägeroberseite 21 als auch an Trägerunterseite 22 des Anschlussträgers 2 sind Anschlussstellen 25a, 25b aufgebracht, die als Metallisierung ausgestaltet sind. Um eine gute Haftung der die Metallisierung bildenden Anschlussstellen 25a, 25b mit dem Grundkörper 27 zu gewährleisten, weist der Grundkörper 27 eine Aufrauung auf oder ist ein Haftvermittler beigegeben. Die Metallisierung wird durch eine 30 µm dicke Kupferschicht gebildet, die in direktem Kontakt zum Grundkörper 27 steht. Auf dieser Kupferschicht ist eine Silberschicht mit einer Dicke von 2 µm aufgebracht. Alternativ zur Silberschicht kann auf der Kupferschicht auch eine Nickel-Goldschicht aufgebracht sein, wobei die Dicke des Goldes bevorzugt weniger als 500 nm beträgt. Jede der Anschlussstellen 25 weist einen Bereich an der Trägeroberseite 21 auf, der zur Kontaktierung eines Halbleiterchips 3 gestaltet ist. An der Trägerunterseite 22 weist jede der elektrisch voneinander isolierten Anschlussstellen 25a, 25b eine Strukturierung auf, die dazu geeignet ist, das Halbleiterbauteil mit einem externen, nicht gezeichneten Träger etwa über Löten oder Kleben zu verbinden.

Die jeweiligen Teile der Anschlussstellen 25a, 25b an Trägeroberseite 21 und Trägerunterseite 22 sind über eine an den einander gegenüberliegenden, von den Ausnehmungen 8 durchdrungenen Trägerflanken 23a, 23b angebrachten Metallisierung elektrisch miteinander verbunden, wobei die durch die Ausnehmung 8 zusätzlich gebildeten Oberflächen des Grundkörpers 27 ebenfalls von der Metallisierung bedeckt sind. Die Trägerflanken 23c, 23d sind frei von einer Metallisierung und somit elektrisch isolierend.

Über der Trägeroberseite 21 ist ein Halbleiterchip 3 über beispielsweise Löten so angebracht, dass dieser in direktem Kontakt zu den Bereichen der Anschlussstellen 25 steht, die sich an der Trägeroberseite 21 befinden. Ebenfalls an der Trägeroberseite 21 ist ein Vergusskörper 4, beispielsweise aus einem Silikon, gebildet. Der kubische Vergusskörper 4 steht sowohl in direktem Kontakt zum Halbleiterchip 3 als auch zum Anschlussträger 2 und schließt im Rahmen der Herstellungstoleranzen bündig mit den Trägerflanken 23c, 23d ab. Anschlussträger 2 und Vergusskörper 4 schließen den Halbleiterchip 3 vollständig ein.

Bevorzugt ist der Grundriss des Anschlussträgers 2 rechteckig, quadratisch oder hexagonal. Die Dicke des Anschlussträgers 2 ist bevorzugt möglichst gering ausgestaltet, wobei der Anschlussträger 2 eine ausreichende mechanische Stabilität aufweist, um etwa ein Verbiegen des Anschlussträgers 2 zu verhindern. Die Dicke des Anschlussträgers 2 ist ≤ 1 mm, bevorzugt ≤ 0,6 mm, besonders bevorzugt ≤ 0,4 mm.

Der Dicke des Halbleiterchips 3 sind keine strikten Grenzen gesetzt, bevorzugt beträgt die Dicke jedoch < 200 µm, besonders bevorzugt < 60 µm, insbesondere < 25 µm. Der Halbleiterchip 3 kann als Dünnfilmchip ausgeformt sein, wie in der Druckschrift WO 2005/081319 A1 beschrieben. Der Halbleiterchip 3 emittiert etwa Licht im nahen ultravioletten oder im blauen Spektralbereich.

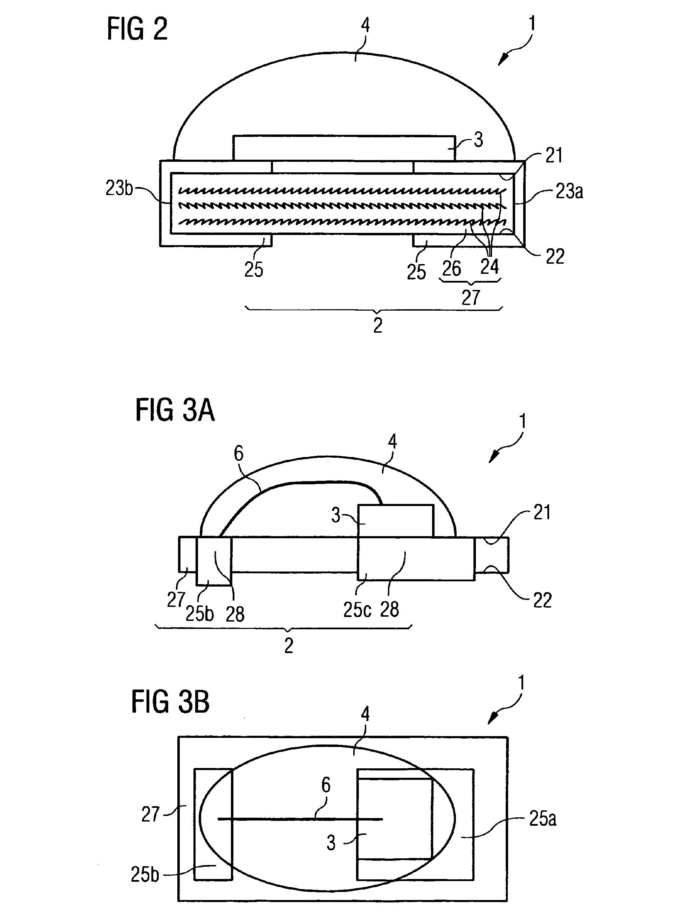

Die Abwandlung gemäß Figur 2 entspricht im Wesentlichen der in Figur 1 gezeigten. Der Vergusskörper 4 ist allerdings als sphärische Linse gestaltet. Der Anschlussträger 2 weist eine dreilagige Faserverstärkung 24 auf, die jeweils, analog zum Ausführungsbeispiel gemäß Figur 1, um 90° gegeneinander verdreht sind. Der Grundkörper 27 des Anschlussträgers 2 weist keine Ausnehmungen 8 auf. Die jeweiligen, sich an Trägeroberseite 21 und Trägerunterseite 22 befindlichen Teile der Anschlussstellen 25 sind über die Trägerflanken 23a, 23b miteinander verbunden.

Bei der Abwandlung gemäß Figur 3 weist der Grundkörper 27 des Anschlussträgers 2 zwei Durchkontaktierungen 28 auf. Die Durchkontaktierungen 28 sind mit einem elektrisch und thermisch leitfähigen Material gefüllt und bilden die Anschlussstellen 25a, 25b aus. Die Anschlussstelle 25a ist hierbei größer gestaltet als die Anschlussstelle 25b. Beide Anschlussstellen 25a, 25b überragen den Grundkörper 27 in Richtung Trägerunterseite 22. Dies erleichtert das Anbringen des Halbleiterbauteils 1 auf einem nicht gezeichneten externen Träger.

An der Trägeroberseite 21 ist der Halbleiterchip 3 direkt auf der Anschlussstelle 25a aufgebracht. Hierdurch wird ein guter thermischer Kontakt vom Halbleiterchip 3 über die Anschlussstelle 25a zu einem nicht gezeichneten, externen Träger gewährleistet. Der zweite elektrische Kontakt des Halbleiterchips 3 befindet sich an einer dem Anschlussträger 2 abgewandten Seite des Chips. Die elektrische Kontaktierung erfolgt über einen Bonddraht 6 zur Anschlussstelle 25b. Beide Anschlussstellen 25a, 25b sowie der Halbleiterchip 3 und der Bonddraht 6 sind von einem linsenartigen Vergusskörper 4 aus einem Silikon überdeckt. Der Vergusskörper 4 steht in direktem Kontakt zum Halbleiterchip 3 und zum Anschlussträger 2 und weist eine sphärisch-ellipsoide Form auf.

Optional ist dem Vergusskörper 4, der auch als Zylinderlinse gestaltet sein kann, mindestens eine Beimengung 7 in Form eines Filtermittels, eines Reflexionsmittels, eines Diffusionsmittels oder eines Konversionsmittels beigegeben. Die Beimengung 7 kann gleichmäßig im Vergusskörper 4 verteilt sein oder auch lokal gehäuft auftreten. Beispielsweise kann die Konzentration einer Beimengung 7 in Bereichen über der dem Anschlussträger 2 abgewandten Seite des Halbleiterchips 3 höher sein, um etwa eine gleichmäßige Konversion von vom Halbleiterchip 3 etwa abgestrahlter elektromagnetischer Strahlung in eine Strahlung einer anderen Wellenlänge zu gewährleisten. Alternativ zum hier gezeigten Halbleiterchip 3, dessen elektrische Kontaktflächen auf zwei einander gegenüberliegenden Hauptseiten sind, kann auch ein als Flip-Chip ausgeführter Halbleiterchip 3 gemäß Figur 1 oder Figur 2 Verwendung finden.

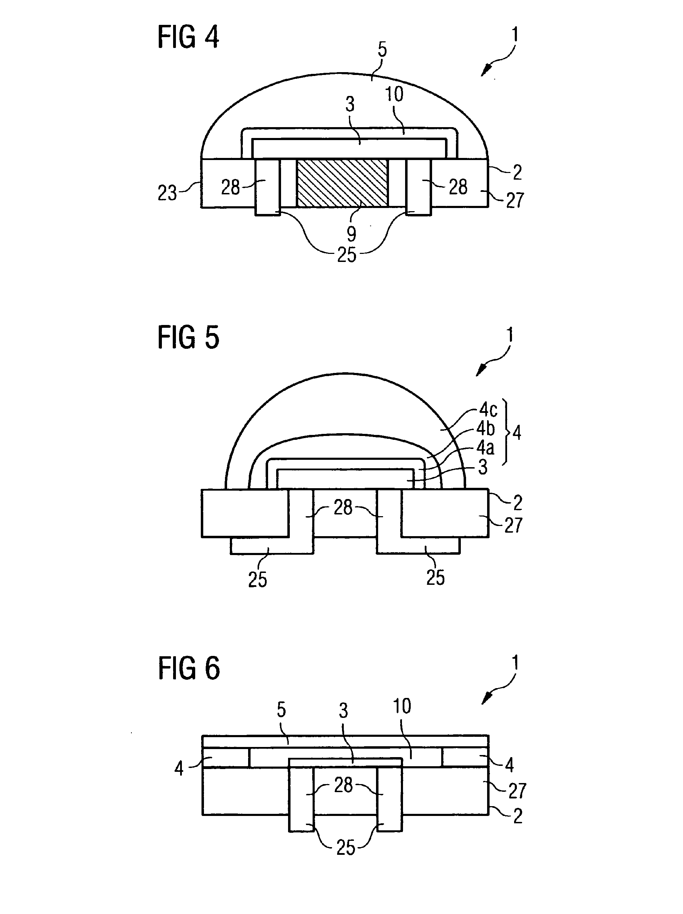

In Figur 4 ist eine weitere Abwandlung eines optoelektronischen Halbleiterbauteils 1 dargestellt. Die elektrische Kontaktierung zu einem nicht gezeichneten externen Träger erfolgt über zwei Durchkontaktierungen 28, mittels derer zwei gleich große Anschlussstellen 25 ausgebildet sind, indem die Durchkontaktierungen 28 mit einem elektrisch leitfähigen Material ausgefüllt sind. Über der Trägeroberseite 21 ist ein Glaskörper 5 angebracht, der für die vom Halbleiterchip 3 zu empfangende oder zu emittierende Strahlung transparent ausgestaltet ist. Zwischen Halbleiterchip 3 und Glaskörper 5 befindet sich ein Gas gefüllter Zwischenraum 10. Das Gas kann zum Beispiel Luft, Argon oder Stickstoff sein. Der Glaskörper 5 ist als linsenartiges Element ausgestaltet und schließt lateral, im Rahmen der Herstellungstoleranzen bündig, mit den Trägerflanken 23 ab.

Optional kann der Zwischenraum 10 mit einem Vergusskörper 4 gefüllt sein. Beim Aufbringen des Glaskörpers 5 weist der Vergusskörper 4 bevorzugt eine flüssige oder zähflüssige Konsistenz auf, so dass über ein Anpressen des Glaskörpers 5 in Richtung des Anschlussträgers 2 der Zwischenraum 10 komplett und formschlüssig ausgefüllt wird. Der Glaskörper 5 kann hierbei eine Öffnung, beispielsweise in lateraler Richtung, aufweisen, so dass Luftblasen und/oder überschüssige, den Vergusskörper 4 bildende Masse aus dem Zwischenraum 10 austreten kann. Über eine derartige Kombination aus Vergusskörper 4 und Glaskörper 5 kann eine besonders stabile Verbindung zwischen Anschlussträger 2 und Glaskörper 5 erzielt werden. Auch lässt sich hierdurch eine gleichmäßige Schichtdicke des Vergusskörpers 4 erzielen, der auch mit einer Beimengung versehen sein kann.

Als weitere Option kann der Anschlussträger 2 eine Wärmesenke 9 aufweisen. Die Wärmesenke 9 erstreckt sich von der Trägeroberseite 21 bis zur Trägerunterseite 22. Die Wärmesenke 9 kann mit der Trägerunterseite 22 bündig abschließen, wie in Figur 4 gezeigt, oder auch die Trägerunterseite 22 in Entsprechung zu den Anschlussstellen 25 überragen. Die Wärmesenke 9 weist bevorzugt eine hohe thermische Leitfähigkeit und auch eine hohe Wärmekapazität auf und ist beispielsweise mit Kupfer gebildet. Ist die Wärmesenke 9 elektrisch leitfähig, so sind elektrische, unerwünschte Kontaktierungen beispielsweise über eine isolierende Schicht zwischen Halbleiterchip 3 oder einem nicht gezeichneten, externen Träger und Wärmesenke 9 vermeidbar.

Bei der Abwandlung gemäß Figur 5 weist der Anschlussträger 2 zwei Durchkontaktierungen 28 auf, die mit einem Metall oder einer Metalllegierung ausgefüllt sind und die Anschlussstellen 25 ausbilden. Die sich an der Trägerunterseite 22 befindlichen Teile der Anschlussstellen 25 sind größer gestaltet als die Querschnittsflächen der Durchkontaktierungen 28. Hierdurch wird ein verbesserter thermischer Kontakt zu einem externen, nicht gezeichneten Träger erzielt.

Der Vergusskörper 4 weist mehrere Schichten 4a, 4b, 4c auf. Eine innerste Schicht 4a kann beispielsweise in einer gleichmäßigen Dicke gestaltet sein, so dass die Schicht 4a den Halbleiterchip 3 mit Ausnahme der dem Anschlussträger 2 zugewandten Seite allseitig in einer gleichmäßigen Dicke umgibt. Hierdurch kann, falls der Schicht 4a ein Konversionsmittel beigegeben ist, eine gleichmäßige Konversion, beispielsweise der vom Halbleiterchip 3 emittierten Strahlung, erzielt werden. Über die Schichten 4b, 4c kann eine Linsenwirkung realisiert werden. Je nach Einstellung der Brechungsindizes der Schichten 4b, 4c zueinander kann die Linsenwirkung verstärkt werden, falls der Brechungsindex der Schicht 4b geringer ist als der der Schicht 4c. Ebenso möglich ist es, dass der Brechungsindex der Schicht 4c kleiner ist als der der Schicht 4b, der wiederum kleiner ist als der der Schicht 4a, der wiederum kleiner ist als der des Halbleiterchips 3. Auf diese Weise kann die Lichtauskoppeleffizienz aus dem Halbleiterchip 3 erhöht werden.

Optional ist die äußerste Schicht 4c des Vergusskörpers 4 mit einem harten Silikon gestaltet, so dass sich ein äußeren Einflüssen gegenüber robustes Halbleiterbauteil 10 ergibt.

Bezüglich Halbleiterchip 3, Anschlussstellen 25 und Anschlussträger 2 entspricht das Ausführungsbeispiel des Halbleiterbauteils 1 gemäß Figur 6 dem in Figur 4 dargestellten. Auf der Trägeroberseite 21 ist ein ringförmiger Vergusskörper 4 angebracht, der in direktem Kontakt zur Trägeroberseite 21 steht, jedoch keinen direkten Kontakt zum Halbleiterchip 3 aufweist. Der Vergusskörper 4 ist mit einem weichen Silikon gestaltet. Über dem Halbleiterchip 3 sowie über den dem Anschlussträger 2 abgewandten Seiten des Vergusskörpers 4 ist ein Glaskörper 5 in Form einer Glasplatte aufgebracht, so dass der Zwischenraum 10 gebildet wird. Über die Verwendung eines weichen Silikons für den Vergusskörper 4 können eventuell im Betrieb des Halbleiterbauteils 1 entstehende thermische Spannungen zwischen Glaskörper 5 und Anschlussträger 2 ausgeglichen werden.

Optional können Glaskörper 5 und/oder Vergusskörper 4, wie in den Abwandlungen gemäß den Figuren 1 bis 5, verschiedene oder auch gleiche Beimengungen beinhalten. Optional können die Anschlussstellen 25 oder auch die dem Halbleiterchip 3 zugewandte Trägeroberseite 21 für die vom Halbleiterchip 3 zu emittierende oder zu empfangende Strahlung reflektierend ausgestaltet sein. Alternativ oder zusätzlich kann der Anschlussträger 2 sowie der Vergusskörper 4 als auch der Glaskörper 5 transparent oder transluzent sein. Nehmen die Anschlussstellen 25 nur eine geringe Fläche ein, so kann sich ein insgesamt im Wesentlichen mindestens teilweise lichtdurchlässiges Halbleiterbauteil 1 ergeben. Weiterhin können mehrere, beispielsweise in verschiedenen Spektralbereichen emittierende Halbleiterchips auf einem einzigen Anschlussträger 2 angebracht sein.

## Patentansprüche

1. Optoelektronisches Halbleiterbauteil (1) mit
- einem Anschlussträger (2) mit mindestens zwei Anschlussstellen (25) und mit einer Trägeroberseite (21),
- mindestens einem optoelektronischen Halbleiterchip (3), der am Anschlussträger (2) an der Trägeroberseite (21) angebracht ist und in direktem Kontakt zu dem Anschlussträger (2) steht,
- einem ringförmigen Vergusskörper (4), der aus einem weichen Silikon gestaltet ist und der in direktem Kontakt zur Trägeroberseite (21) steht, jedoch keinen direkten Kontakt zum Halbleiterchip (3) aufweist,
- einem Glaskörper (5) in Form einer Glasplatte, der auf dem Vergusskörper (4) aufgebracht ist, so dass zwischen dem Halbleiterchip (3) und dem Glaskörper (5) ein Zwischenraum (10) gebildet ist,
wobei der Anschlussträger (2) mit einer Silikonmatrix (26) mit einer Faserverstärkung (24) gestaltet ist, und wobei der Glaskörper (5) und/oder der Vergusskörper (4) optional verschiedene oder auch gleiche Beimengungen beinhalten.

2. Optoelektronisches Halbleiterbauteil (1) nach Anspruch 1,
bei dem die Faserverstärkung (24) mit Glasfasern gebildet ist.

3. Optoelektronisches Halbleiterbauteil (1) nach Anspruch 1 oder 2,
bei dem die Faserverstärkung (24) mindestens dreilagig ist.

4. Optoelektronisches Halbleiterbauteil (1) nach einem der vorhergehenden Ansprüche,
bei dem die Faserverstärkung (24) vollständig von der Silikonmatrix (26) umgeben ist.

5. Optoelektronisches Halbleiterbauteil (1) nach einem der vorhergehenden Ansprüche,
bei dem der Halbleiterchip (3) von dem Glaskörper (5) überdeckt ist.

6. Optoelektronisches Halbleiterbauteil (1) nach einem der vorhergehenden Ansprüche,
bei dem der Halbleiterchip (3) von dem Anschlussträger (2) und von dem Vergusskörper (4) sowie dem Glaskörper (5) vollständig umgeben ist.

7. Optoelektronisches Halbleiterbauteil (1) nach einem der vorhergehenden Ansprüche,
bei dem der Vergusskörper (4) transluzent ist.

## Claims

1. Optoelectronic semiconductor component (1) comprising
- a connection carrier (2) having at least two connection locations (25) and having a carrier top side (21),
- at least one optoelectronic semiconductor chip (3) which is fitted to the connection carrier (2) at the carrier top side (21) and is in direct contact with the connection carrier (2),
- a ring-shaped potting body (4), which is fashioned from a soft silicone and which is in direct contact with the carrier top side (21) but has no direct contact with the semiconductor chip (3),
- a glass body (5) in the form of a glass plate, which is applied on the potting body (4), such that an interspace (10) is formed between the semiconductor chip (3) and the glass body (5),
wherein the connection carrier (2) is fashioned with a silicone matrix (26) having a fibre reinforcement (24), and,
wherein the glass body (5) and/or the potting body (4) optionally comprise different or else identical admixtures.

2. Optoelectronic semiconductor component (1) according to Claim 1,
wherein the fibre reinforcement (24) is formed with glass fibres.

3. Optoelectronic semiconductor component (1) according to Claim 1 or 2,
wherein the fibre reinforcement (24) is at least three-layered.

4. Optoelectronic semiconductor component (1) according to any of the preceding claims,
wherein the fibre reinforcement (24) is completely surrounded by the silicone matrix (26).

5. Optoelectronic semiconductor component (1) according to any of the preceding claims,
wherein the semiconductor chip (3) is covered by the glass body (5).

6. Optoelectronic semiconductor component (1) according to any of the preceding claims,
wherein the semiconductor chip (3) is completely surrounded by the connection carrier (2) and by the potting body (4) and also the glass body (5).

7. Optoelectronic semiconductor component (1) according to any of the preceding claims,
wherein the potting body (4) is translucent.

## Revendications

1. Composant optoélectronique semi-conducteur (1) présentant
un porte-bornes de raccordement (2) présentant au moins deux emplacements de raccordement (25) et un côté supérieur (21) de support,
au moins une puce optoélectronique semi-conductrice (3) placée sur le porte-bornes de raccordement (2) sur le côté supérieur (21) du support et en contact direct avec le porte-bornes de raccordement (2),
un corps annulaire coulé (4) formé d'un silicone déformable et en contact direct avec le côté supérieur (21) du support mais sans contact direct avec la puce semi-conductrice (3),
un corps (5) en verre présentant la forme d'une plaque de verre placée sur le corps coulé (4) de telle sorte qu'un espace intermédiaire (10) soit formé entre la puce semi-conductrice (3) et le corps (5) en verre,
le porte-bornes de raccordement (2) étant configuré avec une matrice (26) en silicone dotée d'un renfort (24) de fibres, le corps (5) en verre et/ou le corps coulé (4) contenant facultativement des additifs différents ou identiques.

2. Composant optoélectronique sémi-conducteur (1) selon la revendication 1, dans lequel le renfort (24) de fibres est formé de fibres de verre.

3. Composant optoélectronique semi-conducteur (1) selon les revendications 1 ou 2, dans lequel le renfort (24) de fibres présente au moins trois couches.

4. Composant optoélectronique semi-conducteur (1) selon l'une des revendications précédentes, dans lequel le renfort (24) de fibres est entouré complètement par la matrice (26) en silicone.

5. Composant optoélectronique semi-conducteur (1) selon l'une des revendications précédentes, dans lequel la puce semi-conductrice (3) est recouverte par le corps (5) en verre.

6. Composant optoélectronique semi-conducteur (1) selon l'une des revendications précédentes, dans lequel la puce semi-conductrice (3) est complètement entourée par le porte-bornes de raccordement (2) et le corps coulé (4) ainsi que par le corps (5) en verre.

7. Composant optoélectronique semi-conducteur (1) selon l'une des revendications précédentes, dans lequel le corps coulé (4) est translucide.
